# EUROPEAN PATENT APPLICATION

(11) **EP 3 333 562 A2**
(43) Date of publication of application: **13.06.2018**
(21) Application number: 17306713.3
(22) Date of filing: 06.12.2017
(51) Int. Cl.: G01M 5/00, F16L 9/00

(54) **REMOTE DETECTION OF INSULATION DAMAGE ON INSULATED TUBES OR PIPES**

(30) Priority: 09.12.2016 NO 20161954
(71) Applicant: Nexans, 92400 Courbevoie (FR)
(72) Inventor: OPSTAD, Ketil, 1712 Gralum (NO); HATLO, Marius, 1671 Fredrikstad (NO); IVERSEN, John, 1738 Borgenhaugen (NO); HAVIK, Eivind, 1715 Sarpsborg (NO); OLSEN, Espen, 1784 Halden (NO)
(74) Representative: Tessier, Benoit Sebastien

(57) **Abstract**

A metallic pipe (19) for the transport of fluid, about which is arranged a protective insulating layer (17). An outer conductive or semi-conductive outer layer (18) is extruded about the protective insulating layer (17). According to one aspect of the invention, a method of detecting damage to the protective insulating layer is provided, comprising performing an electrical test where voltage is applied between the metallic fluid pipe (19) and the outer conductive or semi-conductive layer (18). Voltage drops or voltage instability or current flow indicate structural damage to the protective insulation layer (17).

## Description

The present application is related to steel tubes or pipes, in particular metallic tubes or pipes for the transport of fluids. More particularly the inventions relates to metallic fluid tubes or pipes having a protective layer of insulating material and means for detecting structural damage to said insulating layer. Even more particularly, the invention relates to an arrangement and means for remotely detecting damage to an insulated layer surrounding metallic fluid tubes or pipes.

Metallic tubes or pipes are used in a number of applications, for example in the transport of fluids. Such fluid transporting tubes or pipes are often used offshore, transporting fluids from offshore to onshore and from platform to platform. Umbilicals are commonly used in subsea applications where they are used to connect a floating structure with subsea equipment arranged on the seabed, often in connection with a hydrocarbon well. An umbilical may comprise a variety of cables and tubes or pipes, for example electric cables for transfer of electric power to the subsea equipment, signal cables for transfer of control signals to and from the subsea equipment, fluid tubes or pipes for transport of hydraulic fluid for control of for example valves on the subsea equipment and fluid tubes or pipes for transport of different types of chemicals to be injected into the well stream.

Cables and fluid tubes or pipes are arranged within the umbilical, which usually comprises a number of protective layers such as steel reinforcing layers. Umbilicals are, however, usually open such that there will be water present within the umbilical. The fluid tubes or pipes, which are usually steel tubes or pipes, are therefore provided with a protective layer of an insulating material to protect the fluid tubes or pipes against corrosion.

In the event the insulating material surrounding the metallic tubes or pipes becomes structurally damaged, the underlying pipe may become exposed to AC- corrosive effects of the outside or system environment. One method for detecting such damage is to periodically perform physical inspections of the fluid pipe. This is often not practical or possible, particularly in offshore applications, and especially in the case of fluid tubes or pipes arranged in an umbilical. There is therefore a need to detect remotely any damage to the protective insulating material surrounding the fluid tubes or pipes.

In US 8410789 B2 there is disclosed a high or very high voltage electric cable which comprises an electrically insulating layer, a metal screen and an outer protective sheath. The cable has an extruded, electrically conductive outer layer directly in contact with the outer protective sheath. An electric test may be performed to detect damage to the outer protective sheath, whereby a DC high voltage, e.g. 20kV is applied between the extruded outer conductive layer (which is connected to ground) and the metal screen of the cable. By varying the voltage of the high voltage source, it is possible to verify voltage stability of the load current in order to identify whether the outer protective sheath includes a structural defect.

### Summary of the invention

An object of the present invention is to provide an arrangement and method for detecting damage to a protective insulating layer surrounding a metallic fluid tube or pipe. According to one aspect, the invention provides a metallic tube or pipe for the transport of fluid, about which is arranged a protective insulating layer. An outer conductive or semi-conductive outer layer is extruded externally about the protective insulating layer. According to one aspect of the invention, a method of detecting damage to the protective insulating layer is provided, comprising performing an electrical test where voltage is applied between the metallic fluid pipe and the outer conductive or semi-conductive layer. Voltage drops or voltage instability indicate structural damage to the protective insulation layer. According to one aspect, the voltage source is a test apparatus, a so called "spark tester", more specifically a Elcometer® 266 Holiday Detector. Such device is specifically arranged to detect flaws in protective coatings. According to one aspect, the test apparatus detects a current flow and has a sensitivity setting from a maximum sensitivity of 5µA to a minimum sensitivity of 995µA.

As used herein, the terms "metallic tube or pipe", "fluid tube or pipe", "fluid carrying tube or pipe" or "metallic fluid tube or pipe" means a metallic tube or pipe particularly adapted for the transport of fluids, including a tube or pipe of steel or stainless steel, in particular a steel tube or pipe for offshore applications. "Stainless steel", as used herein, includes ferritic, austenitic or martensitic stainless steel, or ferritic-austenitic stainless steel also referred to as duplex stainless steel, preferably 25Cr duplex steel. The metallic tube or pipe is electrically conductive.

The terms "metallic tube or pipe with a protective insulating layer" or "insulated pipe" or "insulated fluid tube or pipe" as used herein means a fluid tube or pipe as described above, with a protective insulating layer surrounding the tube or pipe. The protective insulating layer is preferably made of an extruded polymer, for example Borstar® HE6063 HD Polyethylene.

As used herein, the material of the outer "conductive layer" or "semi-conductive layer" may comprise a polymer, preferably containing an electrically conductive filler in the range of from 10% to 40% by weight of the filler. Fillers may include carbon black, graphite, carbon nanotubes, doped inorganic fillers and powders of intrinsically conductive polymers.

The term "polymer" refers to a homopolymer or a copolymer and may be a thermoplastic or elastomer polymer. The polymer may comprise a mixture of one or more polar polymers and one or more apolar polymers, for example a linear low-density polyethylene (LLDPE).

As used herein, the term "extruded" means that a layer of conductive or semi-conductive material is uniformly directly deposited onto the protective insulating layer of the insulated fluid pipe. The radial thickness of the conductive or semi-conductive is from 0.1-1mm, preferably from 0.3-0.6mm.

As used herein, the term "high voltage" means a voltage of from 5to50kV DC.

As used herein, the term "electrical test" means applying a high voltage DC current of variable voltage between the metallic tube or pipe and the outer conductive or semi-conductive layer. The voltage may be varied in order to verify voltage stability and the values of the load current delivered by the high voltage source. Drops or increases in the voltage values, identified for example by a test aparatus, signify defects in the insulation layer.

According to one aspect, the electrical test is performed using the conductive layer as ground, and applying voltage on the metallic pipe, in the range of 5-50kV DC. If a fault on the insulating layer is present the voltage source will not be able to maintain the high voltage on the metallic tube. According to one aspect, the electrical test may trigger an alarm in the event a defect in the insulating layer is detected. The metallic tube or pipe will be put in contact with the positive probe of the voltage source at the open end of the tube. The other probe of the voltage source will be connected to earth. The semi-conducting skin outside the PE-insulation will also be connected to earth. The voltage is set on the voltage source according to applicable standard. The voltage will then be applied to the tube. If there is a defect in the insulation, the voltage will drop and the voltage source indicates by light/sound or other alarm/indicator.

### Brief description of the drawings

The invention will be described in more detail with reference to the following figures, wherein:
Fig 1 is a cross sectional view of an umbilical arrangement.
Fig 2 is cross sectional view of a fluid-carrying metallic tube or pipe having an insulating layer and an outer layer of conductive or semi conductive material.
Fig 3 illustrates the electrical test arrangement.

### Detailed description

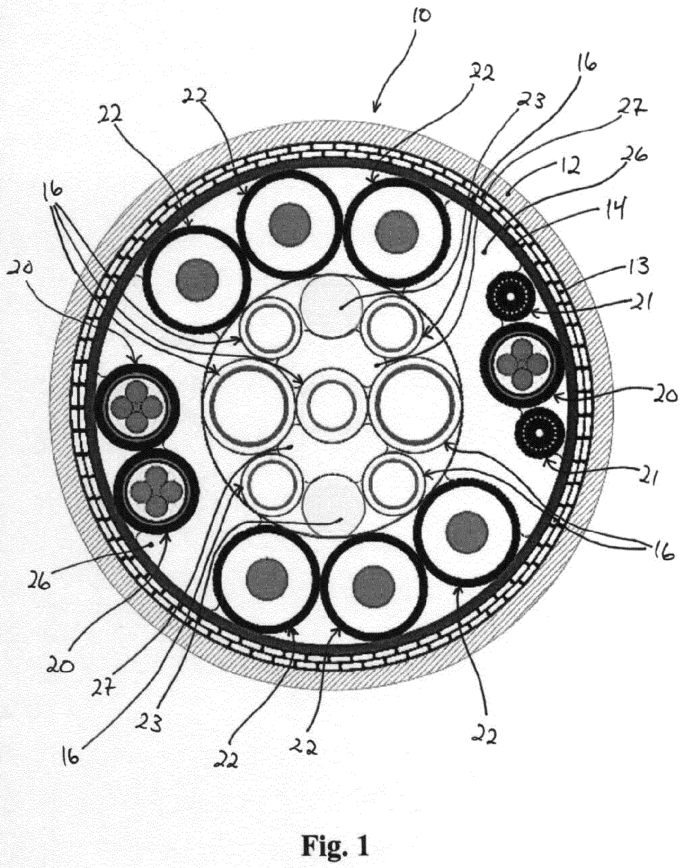

Figure 1 illustrates a typical arrangement of an umbilical 10. The umbilical comprises an inner sheath 14, an armoring layer 13 and an outer sheath 12. Disposed within the inner sheath 14 may be one or more power cables 22, one or more electrical quad elements 20, one or more fiber optic cables 21 held in place by one or more filler elements 26. Disposed with umbilical may also be one or more fluid carrying tubes or pipes 16 held in place by one or more filler elements 27. The umbilical may also comprise one or more strengthening elements 23.

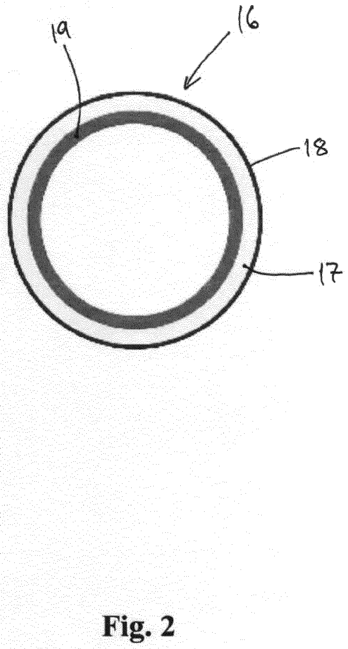

Figure 2 illustrates the arrangement of a fluid carrying tube or pipe 16 from figure 1, according to the invention. The fluid carrying tube or pipe 16 comprises a central metallic, preferably steel tube or pipe 19 made, for example of 25Cr duplex steel tubing. Surrounding the metallic tube or pipe 19 is a protective insulating layer 17. An outer conductive or semi-conductive layer 18 is extruded using techniques known in the art about protective insulating layer 17.

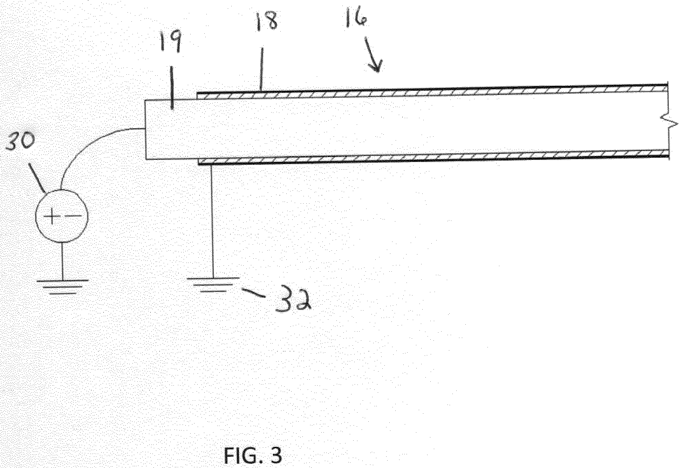

In order to remotely detect structural damage an arrangement for performing an electrical test is provided. As shown in Fig 3 the arrangement comprises a test apparatus comprising a high voltage source 30 connected to the conductive layer 18 and the metallic tube or pipe 19. According to one aspect, the voltage source comprises a test apparatus known as a so called "spark tester", for example an Elcometer® 266 Holiday Detector. The conductive layer 18 is connected to ground 32. A voltage, possibly a variable voltage, is thereafter applied on the metallic pipe 19 in the range of 5-50kV DC depending on the insulation thickness. The test apparatus detects drops in voltage and signals an alarm.

### Expected results

The test confirms structural integrity of the protective insulating layer 17 if the applied voltage remains relatively constant. Drops in voltage, voltage instability or a flow of electrical current indicates structural damage to the protective insulating layer 17.

## Claims

1. A fluid tube or pipe arrangement (16) for transport of a fluid, the fluid tube or pipe arrangement comprising a central electrically conductive metallic tube or pipe (19) surrounded by a protective insulating layer (17) for protection of the metallic tube or pipe (19) against water and/or moisture, wherein the protective insulating layer (17) is arranged substantially concentrically on the metallic tube or pipe (19), **characterized in that** the fluid tube or pipe arrangement (16) further comprises an outer layer (18) comprising a conductive or semi-conductive material arranged about the protective insulating layer (17).

2. A fluid tube or pipe arrangement according claim 1, further comprising a voltage source (30) for applying a voltage between the metallic tube or pipe (19) and outer layer (18), said voltage source comprising means for detecting changes in voltage values or current flow, said voltage source arranged to detect a drop or instability in voltage values or the presence of a current flow indicative of a structural defect in protective insulating layer (17).

3. A fluid tube or pipe arrangement according claim 2, wherein the voltage source is a spark tester.

4. A fluid tube or pipe arrangement according claim 3, wherein the spark tester is arranged to detect a current flow, and has a sensitivity setting of from 5-99 µA.

5. A fluid tube or pipe arrangement according to one of the preceding claims, **characterized in that** the outer layer (18) comprises a conductive or semi-conductive polymer.

6. A fluid tube or pipe arrangement according to claim 5, **characterized in that** the polymer comprises a mixture of one or more polar polymers and one or more apolar polymers.

7. A fluid tube or pipe arrangement according to one of the preceding claims, **characterized in that** the outer layer (18) comprises a polymer containing an electrically conductive filler in the range of from 10% to 40% by weight of the filler.

8. A fluid tube or pipe arrangement according to claim 7, **characterized in that** the filler is selected from the group consisting of carbon black, graphite, carbon nanotubes, doped inorganic fillers and powders of intrinsically conductive polymers.

9. A fluid tube or pipe arrangement according to one of the preceding claims, **characterized in that** the outer layer (18) comprises a linear low-density polyethylene (LLDPE).

10. A fluid tube or pipe arrangement according one of the preceding claims, **characterized in that** the radial thickness of the outer layer (18) is in the range 0.1mm-1mm, preferably 0.3mm-0.6mm.

11. A fluid tube or pipe arrangement according to one of the preceding claims, **characterized in that** the metallic tube or pipe (19) is a steel tube or pipe made of duplex stainless steel, preferably 25Cr duplex steel.

12. A fluid tube or pipe arrangement according to one of the preceding claims, **characterized in that** the metallic tube or pipe (19) is a subsea tube or pipe arranged inside an umbilical (10).

13. A fluid tube or pipe arrangement according to claim 12, wherein the voltage source (30) is arranged to provide a voltage in the range of 5 to 50kV DC, depending on the thickness of the insulating layer 17.

14. A method for detecting structural defects in a protective insulating layer (17) of a fluid tube or pipe arrangement (16), comprising the steps of:
a. Providing a fluid tube or pipe arrangement according to any one of claims 1-11,
b. Applying a voltage between the metallic tube or pipe (19) and the outer layer (18) with a voltage source (30), said voltage source comprising means for detecting drops or instability in voltage value or current flow,
c. Detecting a drop or instability in voltage value or a current flow, wherein such drop or instability in voltage value or current flow is indicative of a structural defect in the protective insulating layer (17).

15. Method according to claim 14, wherein the voltage source (30) is a spark tester.

16. Method according to claim 14, wherein the spark tester is arranged to detect a current flow, and has a sensitivity setting of from 5-99 µA.

17. Method according to either of claims 14-16, wherein the voltage is in the range of 5 to 50kV DC, depending on the thickness of the insulation layer.
